# EUROPÄISCHE PATENTSCHRIFT

(11) **EP 3 274 756 B1**
(45) Veröffentlichungstag und Bekanntmachung des Hinweises auf die Patenterteilung: **04.05.2022**
(21) Anmeldenummer: 16710720.0
(22) Anmeldetag: 16.03.2016
(51) Int. Cl.: G02B 26/08

(54) **VIELSPIEGEL-ANORDNUNG**
MULTI-MIRROR ARRAY
ENSEMBLE À MIROIRS MULTIPLES

(30) Priorität: 25.03.2015 DE 102015205404
(43) Veröffentlichungstag der Anmeldung: 31.01.2018
(73) Patentinhaber: Carl Zeiss SMT GmbH, 73447 Oberkochen (DE)
(72) Erfinder: HORN, Jan, 80639 München (DE); TÜRK, Stefan, 79346 Endingen (DE); NOORDMAN, Oscar, 5263 CB Vught (NL); BIHR, Ulrich, 73467 Kirchheim / Dirgenheim (DE)
(74) Vertreter: Rau, Schneck & Hübner Patentanwälte Rechtsanwälte PartGmbB
(86) Internationale Anmeldenummer: PCT/EP2016/055621
(87) Internationale Veröffentlichungsnummer: WO 2016/150779

(56) Entgegenhaltungen:
- WO-A1-03/079090
- DE-A1-102013 206 531
- US-A1- 2014 327 896

## Beschreibung

Die Erfindung betrifft eine Vielspiegel-Anordnung, insbesondere eine Vielspiegel-Anordnung für eine Beleuchtungsoptik einer Projektionsbelichtungsanlage. Die Erfindung betrifft außerdem einen Facettenspiegel für eine Beleuchtungsoptik einer Projektionsbelichtungsanlage, eine Beleuchtungsoptik für eine Projektionsbelichtungsanlage mit einem derartigen Facettenspiegel, ein Beleuchtungssystem mit einer derartigen Beleuchtungsoptik und eine Projektionsbelichtungsanlage mit einer derartigen Beleuchtungsoptik. Schließlich betrifft die Erfindung ein Verfahren zur Herstellung eines mikro- oder nanostrukturierten Bauelements sowie ein nach diesem Verfahren hergestelltes Bauelement.

Eine Vielspiegel-Anordnung (Multi Mirror Array, MMA) für eine Beleuchtungsoptik einer Projektionsbelichtungsanlage ist beispielsweise aus der WO 2013/120926 A1 bekannt. Aufgrund von geringen Dämpfungskoeffizienten sind die Einzelspiegel einer derartigen Vielspiegel-Anordnung sehr sensitiv im Hinblick auf störende Anregungen. Aus der DE 10 2013 203 035 A1 ist eine schwingungsdämpfende Gestaltung eines Dämpfungsabschnitts zur Dämpfung von Schwingungen entsprechender Einzelspiegel bekannt.

Die WO 2003/079 090 A1 zeigt ein verbessertes Adressierungsverfahren für bewegliche Elemente in einen räumlichen Lichtmodulator.

Eine Aufgabe der Erfindung besteht darin, eine Vielspiegel-Anordnung zu verbessern.

Diese Aufgabe wird durch eine Vielspiegel-Anordnung mit passiven elektrischen Dämpfungsmitteln zur Dämpfung von Störungen der Verlagerungspositionen der Spiegelelemente gelöst. Die Dämpfungsmittel sind jeweils in Reihenschaltung mit einer der Aktuator-Elektroden, welche zur Verlagerung der Spiegel-Elemente mit Aktuations-Signalen beaufschlagbar sind, angeordnet. Einzelne Teile des Dämpfungsmittels können auch zumindest kurzzeitig parallel zu den Aktuator-Elektroden geschaltet sein.

Erfindungsgemäß wurde erkannt, dass sich die Stabilität der Positionierung der Spiegel-Elemente mit Hilfe derartiger passiver Dämpfungsmittel erheblich verbessern lässt. Passive Dämpfungsmittel lassen sich außerdem sehr einfach realisieren. Sie sind insbesondere wesentlich weniger komplex als aktive Dämpfungssysteme. Sie sind darüber hinaus weniger anfällig gegen Rauschen aus der Signalleitung. Schließlich sind sie besonders einfach in ein System integrierbar.

Unter passivem Dämpfungsmittel seien hierbei im Gegensatz zu aktiven Dämpfungssystemen Dämpfungsmittel verstanden, welche keine Messeinrichtung zur Erfassung der Verlagerungsposition der Spiegel-Elemente oder deren zeitliche Ableitung aufweisen. Insbesondere die lokale elektrische Schaltung weist keine derartige Messeinrichtung auf. Eine derartige Messeinrichtung kann allenfalls als externe Messeinrichtung, das heißt als separates Bauteil vorgesehen sein. Die externe Messeinrichtung wird dann aber insbesondere zur überlagerten Positionsregelung und nicht zur Dämpfung eingesetzt.

Bei den Spiegel-Elementen handelt es sich insbesondere um Mikrospiegel. Die Spiegel-Elemente weisen insbesondere Reflexionsflächen im Bereich von 100 µm ^{∗} 100 µm bis 10 mm ^{∗} 10 mm auf. Die Seitenlänge der Mikrospiegel beträgt insbesondere mindestens 200 µm, insbesondere mindestens 300 µm, insbesondere mindestens 500 µm. Sie beträgt insbesondere höchstens 5 mm, insbesondere höchstens 3 mm, insbesondere höchstens 2 mm, insbesondere höchstens 1 mm.

Bei den Spiegel-Elementen handelt es sich insbesondere um EUV-Spiegel, das heißt um Spiegel zur Reflexion von Beleuchtungsstrahlung im EUV-Bereich, insbesondere im Bereich von 5 nm bis 30 nm, insbesondere im Bereich von 5 nm bis 13,5 nm.

Die Vielspiegel-Anordnung ist insbesondere als mikroelektromechanisches System (MEMS) ausgebildet.

Bei den Aktuatoren zur Verlagerung der Spiegel-Elemente handelt es sich insbesondere um elektrische Aktuatoren, insbesondere um elektrostatische Aktuatoren.

Gemäß einem weiteren Aspekt der Erfindung ist zumindest einer der Aktuator-Elektroden jedem Verlagerungsfreiheitsgrad jedes der Spiegel-Elemente ein Dämpfungsmittel zugeordnet. Es ist insbesondere möglich, jeder der Aktuator-Elektroden ein Dämpfungsmittel zuzuordnen.

Gemäß einem weiteren Aspekt der Erfindung sind die Dämpfungsmittel jeweils zwischen einem Aktuator-Verstärker und einer der Aktuator-Elektroden angeordnet. Sie sind insbesondere in der Signalleitung von einer Steuer-Einrichtung zur Steuerung der Verlagerung der Spiegel-Elemente angeordnet. Sie können einen Bestandteil einer derartigen Signalleitung bilden.

Gemäß einem weiteren Aspekt der Erfindung sind die Dämpfungsmittel jeweils als Energie-Dissipations-Einrichtung ausgebildet. Sie sind insbesondere jeweils als Widerstands-Einrichtung ausgebildet. Erfindungsgemäß wurde erkannt, dass durch eine derartige Dissipation von Energie eine Dämpfung der Spiegel-Elemente erreicht werden kann. Gemäß einem weiteren Aspekt der Erfindung umfassen die Dämpfungsmittel mindestens ein Mittel ausgewählt aus der Gruppe von anti-parallel geschalteten Dioden, Schaltkondensatorstrukturen (Switched-Capacitor-Strukturen) und Transistorschaltungen. Hierbei weisen die drei Alternativen, anti-parallel geschaltete Dioden, Schaltkondensatorstrukturen und Transistorschaltungen, den Vorteil auf, dass sie sich mit einem wesentlich geringeren Bauraum realisieren lassen als Serienwiderstände.

Erfindungsgemäß wurde erkannt, dass sich durch jedes dieser Mittel ein geeigneter effektiver Serienwiderstand realisieren lässt. Details der unterschiedlichen Alternativen ergeben sich aus der Beschreibung der entsprechenden Ausführungsbeispiele.

Gemäß einem Aspekt der Erfindung sind sämtliche Dämpfungsmittel der Vielspiegel-Anordnung entsprechend ausgebildet. Es ist insbesondere möglich, sämtliche Dämpfungsmittel der Vielspiegel-Anordnung identisch auszubilden. Alternativ hierzu ist eine Kombination unterschiedlicher Dämpfungsmittel ausgewählt aus der oben genannten Gruppe von Dämpfungsmitteln möglich.

Gemäß einem weiteren Aspekt der Erfindung sind die Dämpfungsmittel variabel einstellbar. Sie weisen insbesondere einen einstellbaren Widerstand auf. Hierdurch wird eine Einstellbarkeit der Dämpfungsmittel, insbesondere eine Anpassung an die zu dämpfenden Frequenzen der Einzelspiegel ermöglicht.

Gemäß einem weiteren Aspekt der Erfindung sind die Dämpfungsmittel jeweils als on-ASIC-Strukturen (Strukturen auf einem ASIC, Application Specific Integrated Circuit, anwendungsspezifischer integrierter Schaltkreis) ausgebildet. Hierdurch wird eine besonders einfache Integration in die Steuerelektronik zur Steuerung der Aktuierung der Spiegel-Elemente ermöglicht.

Gemäß einem weiteren Aspekt der Erfindung sind die Dämpfungsmittel jeweils als Strukturen mit einer Fläche von höchstens 10 %, insbesondere höchstens 5 %, insbesondere höchstens 3 %, insbesondere höchstens 2 %, insbesondere höchstens 1 %, insbesondere höchstens 0,5 %, insbesondere höchstens 0,3 %, insbesondere höchstens 0,2 %, insbesondere höchstens 0,1 % der Reflexionsfläche des zugehörigen Spiegel-Elements ausgebildet. Die zur Ausbildung der Strukturen auf dem ASIC benötigte Fläche wird auch als Footprint (Fußabdruck) bezeichnet. Der Footprint der als Dämpfungsmittel dienenden Strukturen beträgt insbesondere höchstens 10⁵ µm², insbesondere höchstens 5 ^{∗} 10⁴ µm², insbesondere höchstens 3 ^{∗} 10⁴ µm², insbesondere höchstens 2 ^{∗} 10⁴ µm², insbesondere höchstens 1 ^{∗} 10⁴ µm², insbesondere höchstens 5 ^{∗} 10³ µm², insbesondere höchstens 3 ^{∗} 10³ µm², insbesondere höchstens 2 ^{∗} 10³ µm², insbesondere höchstens 1,8 ^{∗} 10³ µm², insbesondere höchstens 1,5 ^{∗} 10³ µm². Dies stellt eine erhebliche Reduzierung der benötigten Fläche relativ zu bislang bekannten Dämpfungsmitteln, insbesondere zu ohmschen Serienwiderständen, dar.

Gemäß einem weiteren Aspekt der Erfindung weisen die Dämpfungsmittel jeweils einen effektiven Serienwiderstand im Bereich von 1 MΩ bis 100 GΩ auf. Der effektive Serienwiderstand der Dämpfungsmittel beträgt vorzugsweise mindestens 5 MΩ, insbesondere mindestens 10 MΩ, insbesondere mindestens 20 MΩ. Der effektive Serienwiderstand der Dämpfungsmittel beträgt insbesondere höchstens 10 GΩ, insbesondere höchstens 1 GΩ, insbesondere höchstens 100 MΩ.

Es konnte gezeigt werden, dass sich mit derartigen Widerstandswerten eine effiziente Dämpfung von Störungen der Verlagerungspositionen der Spiegel-Elemente erreichen ließ.

Gemäß einem weiteren Aspekt der Erfindung ist die Vielspiegel-Anordnung modular ausgebildet. Die Vielspiegel-Anordnung ist insbesondere derart modular ausgebildet, dass sich eine Gesamtreflexionsfläche durch eine Anordnung mehrerer derartiger Vielspiegel-Anordnungen im Wesentlichen beliebig erweitern lässt.

Durch die modulare Ausbildung der Vielspiegel-Anordnung wird insbesondere die Flexibilität derselben erhöht.

Weitere Aufgaben der Erfindung bestehen darin, einen Facettenspiegel für eine Beleuchtungsoptik einer Projektionsbelichtungsanlage, eine derartige Beleuchtungsoptik, ein Beleuchtungssystem mit einer derartigen Beleuchtungsoptik und eine Projektionsbelichtungsanlage zu verbessern.

Diese Aufgaben werden durch die entsprechenden Strukturen gelöst, welche jeweils mindestens eine Vielspiegel-Anordnung gemäß der vorhergehenden Beschreibung umfassen. Die Vorteile ergeben sich aus denen der Vielspiegel-Anordnung.

Weitere Aufgaben der Erfindung bestehen darin, ein Verfahren zur Herstellung eines mikro- oder nanostrukturierten Bauelements sowie ein derartiges Bauelement zu verbessern.

Diese Aufgaben werden durch Bereitstellung einer Projektionsbelichtungsanlage mit einer Vielspiegel-Anordnung gemäß der vorhergehenden Beschreibung gelöst. Die Vorteile ergeben sich wiederum aus denen der Vielspiegel-Anordnung.

Weitere Vorteile und Details der Erfindung ergeben sich aus der Beschreibung mehrerer Ausführungsbeispiele anhand der Figuren. Es zeigen:
- Fig. 1: schematisch eine Projektionsbelichtungsanlage für die Mikrolithographie mit einem Beleuchtungssystem und einer Projektionsoptik im Meridionalschnitt,
- Fig. 2: eine schematische Darstellung eines einzelnen SpiegelElements einer Vielspiegel-Anordnung mit einem Dämpfungsmittel in Form eines Reihenwiderstandes,
- Fig. 3: eine schematische Darstellung eines Modells zur Beschreibung des elektromechanischen Systems des Spiegel-Elements gemäß Fig. 2,
- Fig. 4: eine exemplarische Darstellung der Abhängigkeit des Dämpfungskoeffizienten vom Wert des Reihenwiderstandes aus dem Modell gemäß Fig. 3,
- Fig. 5: eine Darstellung gemäß Fig. 2 einer Ausführungsform, bei welcher das Dämpfungsmittel durch anti-parallel geschaltete Dioden realisiert ist,
- Fig. 6: eine Darstellung entsprechend Fig. 2 eines weiteren Ausführungsbeispiels, bei welchem das Dämpfungsmittel als Schaltkondensatorstruktur realisiert ist,
- Fig. 7: eine Darstellung entsprechend Fig. 6 mit einer alternativen Schaltkondensatorstruktur, und
- Fig. 8: eine Darstellung entsprechend Fig. 2 eines weiteren Ausführungsbeispiels, bei welchem das Dämpfungsmittel durch eine Transistorschaltung realisiert ist.

Im Folgenden wird zunächst der prinzipielle Aufbau einer Projektionsbelichtungsanlage 1 anhand der Figuren beschrieben. Die Beschreibung des prinzipiellen Aufbaus der Projektionsbelichtungsanlage 1 ist exemplarisch zu verstehen. Alternative Ausführungen sind möglich.

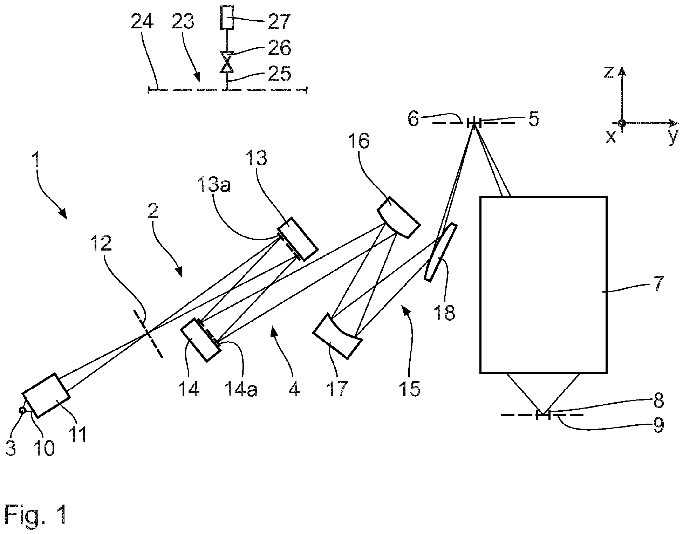

Fig. 1 zeigt schematisch in einem Meridionalschnitt eine Projektionsbelichtungsanlage 1 für die Mikrolithografie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes und in der Fig. 1 nicht dargestelltes reflektierendes Retikel, das eine mit der Projektionsbelichtungsanlage 1 zur Herstellung mikro- beziehungsweise nanostrukturierter HalbleiterBauelemente zu projizierende Struktur trägt. Eine Projektionsoptik 7 dient zur Abbildung des Objektfeldes 5 in ein Bildfeld 8 in einer Bildebene 9. Abgebildet wird die Struktur auf dem Retikel auf eine lichtempfindliche Schicht eines im Bereich des Bildfeldes 8 in der Bildebene 9 angeordneten Wafers, der in der Zeichnung nicht dargestellt ist.

Das Retikel, das von einem nicht dargestellten Retikelhalter gehalten ist, und der Wafer, der von einem nicht dargestellten Waferhalter gehalten ist, werden beim Betrieb der Projektionsbelichtungsanlage 1 synchron in der y-Richtung gescannt. Abhängig vom Abbildungsmaßstab der Projektionsoptik 7 kann auch ein gegenläufiges Scannen des Retikels relativ zum Wafer stattfinden.

Mit Hilfe der Projektionsbelichtungsanlage 1 wird wenigstens ein Teil des Retikels auf einen Bereich einer lichtempfindlichen Schicht auf dem Wafer zur lithographischen Herstellung eines mikro- beziehungsweise nanostrukturierten Bauelements, insbesondere eines Halbleiterbauelements, zum Beispiel eines Mikrochips abgebildet. Je nach Ausführung der Projektionsbelichtungsanlage 1 als Scanner oder als Stepper werden das Retikel und der Wafer zeitlich synchronisiert in der y-Richtung kontinuierlich im Scannerbetrieb oder schrittweise im Stepperbetrieb verfahren.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

EUV-Strahlung 10, die von der Strahlungsquelle 3 ausgeht, wird von einem Kollektor 11 gebündelt. Ein entsprechender Kollektor ist beispielsweise aus der EP 1 225 481 A bekannt. Nach dem Kollektor 11 propagiert die EUV-Strahlung 10 durch eine Zwischenfokusebene 12, bevor sie auf einen Feldfacettenspiegel 13 mit einer Vielzahl von Feldfacetten 13a trifft. Der Feldfacettenspiegel 13 ist in einer Ebene der Beleuchtungsoptik 4 angeordnet, die zur Objektebene 6 optisch konjugiert ist.

Die EUV-Strahlung 10 wird nachfolgend auch als Nutzstrahlung, Beleuchtungslicht oder als Abbildungslicht bezeichnet.

Nach dem Feldfacettenspiegel 13 wird die EUV-Strahlung 10 von einem Pupillenfacettenspiegel 14 mit einer Vielzahl von Pupillenfacetten 14a reflektiert. Der Pupillenfacettenspiegel 14 liegt entweder in der Eintrittspupillenebene der Beleuchtungsoptik 7 oder in einer hierzu optisch konjugierten Ebene. Der Feldfacettenspiegel 13 und der Pupillenfacettenspiegel 14 sind aus einer Vielzahl von Einzelspiegeln aufgebaut, die nachfolgend noch näher beschrieben werden. Dabei kann die Unterteilung des Feldfacettenspiegels 13 in Einzelspiegel derart sein, dass jede der Feldfacetten 13a, die für sich das gesamte Objektfeld 5 ausleuchten, durch genau einen der Einzelspiegel repräsentiert wird. Alternativ ist es möglich, zumindest einige oder alle der Feldfacetten 13a durch eine Mehrzahl derartiger Einzelspiegel aufzubauen. Entsprechendes gilt für die Ausgestaltung der den Feldfacetten 13a jeweils zugeordneten Pupillenfacetten 14a des Pupillenfacettenspiegels 14, die jeweils durch einen einzigen Einzelspiegel oder durch eine Mehrzahl derartiger Einzelspiegel gebildet sein können.

Die EUV-Strahlung 10 trifft auf die beiden Facettenspiegel 13, 14 unter einem Einfallswinkel, gemessen normal zur Spiegelfläche, auf, der kleiner oder gleich 25° ist. Die beiden Facettenspiegel 13, 14 werden also im Bereich eines normal incidence-Betriebs mit der EUV-Strahlung 10 beaufschlagt. Auch eine Beaufschlagung unter streifendem Einfall (grazing incidence) ist möglich. Der Pupillenfacettenspiegel 14 ist in einer Ebene der Beleuchtungsoptik 4 angeordnet, die eine Pupillenebene der Projektionsoptik 7 darstellt beziehungsweise zu einer Pupillenebene der Projektionsoptik 7 optisch konjugiert ist. Mithilfe des Pupillenfacettenspiegels 14 und einer abbildenden optischen Baugruppe in Form einer Übertragungsoptik 15 mit in der Reihenfolge des Strahlengangs für die EUV-Strahlung 10 bezeichneten Spiegeln 16, 17 und 18 werden die Feldfacetten des Feldfacettenspiegels 13 einander überlagernd in das Objektfeld 5 abgebildet. Der letzte Spiegel 18 der Übertragungsoptik 15 ist ein Spiegel für streifenden Einfall ("Grazing incidence Spiegel"). Die Übertragungsoptik 15 wird zusammen mit dem Pupillenfacettenspiegel 14 auch als Folgeoptik zur Überführung der EUV-Strahlung 10 vom Feldfacettenspiegel 13 hin zum Objektfeld 5 bezeichnet. Das Beleuchtungslicht 10 wird von der Strahlungsquelle 3 hin zum Objektfeld 5 über eine Mehrzahl von Ausleuchtungskanälen geführt. Jedem dieser Ausleuchtungskanäle ist eine Feldfacette 13a des Feldfacettenspiegels 13 und eine dieser nachgeordnete Pupillenfacette 14a des Pupillenfacettenspiegels 14 zugeordnet. Die Einzelspiegel des Feldfacettenspiegels 13 und des Pupillenfacettenspiegels 14 können aktuatorisch verkippbar sein, sodass ein Wechsel der Zuordnung der Pupillenfacetten 14a zu den Feldfacetten 13a und entsprechend eine geänderte Konfiguration der Ausleuchtungskanäle erreicht werden kann. Es resultieren unterschiedliche Beleuchtungssettings, die sich in der Verteilung der Beleuchtungswinkel des Beleuchtungslichts 10 über das Objektfeld 5 unterscheiden.

Zur Erleichterung der Erläuterung von Lagebeziehungen wird nachfolgend unter anderem ein globales kartesisches xyz-Koordinatensystem verwendet. Die x-Achse verläuft in der Fig. 1 senkrecht zur Zeichenebene auf den Betrachter zu. Die y-Achse verläuft in der Fig. 1 nach rechts. Die z-Achse verläuft in der Fig. 1 nach oben.

In ausgewählten der nachfolgenden Figuren ist ein lokales kartesisches xyz-Koordinatensystem eingezeichnet, wobei die x-Achse parallel zur x-Achse nach der Fig. 1 verläuft und die y-Achse mit dieser x-Achse die optische Fläche des jeweiligen optischen Elements aufspannt. Der Feldfacettenspiegel 13 ist als Mikrospiegel-Array (Mircomirror Array, MMA) ausgebildet. Er bildet ein Beispiel einer Vielspiegel-Anordnung. Er bildet insbesondere eine optische Baugruppe zur Führung der Nutzstrahlung 10, also des EUV-Bestrahlungsbündels. Der Feldfacettenspiegel 13 ist als mikroelektromechanisches System (MEMS) ausgebildet. Er weist eine Vielzahl von matrixartig zeilen- und spaltenweise in einem Array angeordneten Einzelspiegel auf. Die Einzelspiegel werden im Folgenden auch als SpiegelElemente 19 bezeichnet. Die Spiegel-Elemente 19 sind aktuatorisch verkippbar ausgelegt, wie nachfolgend noch erläutert wird. Insgesamt weist der Feldfacettenspiegel 13 etwa 100000 der Spiegel-Elemente 19 auf. Je nach Größe der Spiegel-Elemente 19 kann der Feldfacettenspiegel 13 auch beispielsweise etwa 1000, 10000 oder auch mehrere Hunderttausend, beispielsweise 200000, 300000 oder 500000 Spiegel-Elemente 19 aufweisen. Die Spiegel-Elemente 19 sind als Mikrospiegel ausgebildet. Sie weisen jeweils eine Reflexionsfläche 20 mit Abmessungen im Mikrometerbereich oder Millimeterbereich auf. Die Reflexionsfläche 20 ist insbesondere polygonal, insbesondere dreieckig, viereckig oder sechseckig ausgebildet. Sie ist vorzugsweise derart ausgebildet, dass sie ein Kachelelement bildet, mit welchem eine Ebene parkettierbar ist. Sie ist vorzugsweise quadratisch ausgebildet. Sie weist vorzugsweise eine Seitenlänge auf, welche im Bereich von 100 µm bis 10 mm liegt. Die Seitenlänge der Reflexionsfläche 20 beträgt insbesondere mindestens 200 µm, insbesondere mindestens 300 µm, insbesondere mindestens 500 µm. Sie beträgt insbesondere höchstens 5 mm, insbesondere höchstens 3 mm, insbesondere höchstens 2 mm, insbesondere höchstens 1 mm.

Die Reflexionsfläche 20 umfasst eine Multilayer-Beschichtung zur Optimierung ihrer Reflektivität bei der Wellenlänge der Nutzstrahlung 10.

Die Beleuchtungsoptik 4 ist, wie in der Fig. 1 schematisch angedeutet ist, in einer evakuierbaren Kammer 23 angeordnet. Von der evakuierbaren Kammer 23 ist in der Fig. 1 lediglich schematisch eine Begrenzungswand 24 angedeutet. Die Kammer 23 kommuniziert über eine Fluidleitung 25, in der ein Absperrventil 26 untergebracht ist, mit einer Vakuumpumpe 27. Der Betriebsdruck in der evakuierbaren Kammer 23 beträgt einige Pa (Partialdruck H₂). Alle anderen Partialdrücke liegen deutlich unterhalb von 10⁻⁷ mbar. Die Spiegel-Elemente 19 sind in einem Substrat 21 angeordnet. Dieses ist über einen Wärmeleitungsabschnitt 22 mit den Spiegel-Elementen 19 mechanisch verbunden. Teil des Wärmeleitungsabschnittes 22 ist ein Gelenkkörper 28, der eine Verkippung des Spiegel-Elements 19 relativ zum Substrat 21 zulässt. Der Gelenkkörper 28 kann als Festkörpergelenk ausgebildet sein, das eine Verkippung des Spiegel-Elements 19 um definierte Kipp-Achsen, beispielsweise um eine oder um zwei, insbesondere senkrecht zueinander angeordnete, Kipp-Achsen zulässt.

Das Spiegel-Element 19 ist insbesondere um einen Kippwinkel im Bereich von mindestens ± 50 mrad, insbesondere mindestens ± 80 mrad, insbesondere mindestens ± 100 mrad, verschwenkbar. Die jeweilige Kippposition kann hierbei mit einer Genauigkeit von mindestens 0,2 mrad, insbesondere mindestens 0,1 mrad, insbesondere mindestens 0,05 mrad, eingehalten werden. Für weitere Details des Spiegel-Elements 19, insbesondere dessen geometrischen Ausbildung und mechanischen Lagerung, sei auf die WO 2013/120926 A1 verwiesen, die hiermit vollständig in die vorliegende Anmeldung integriert sei. Lediglich schematisch sei auf einen Aktuatorstift 29 hingewiesen, welcher mechanisch über einen Haltekörper 30 und einen Abstandshalter 31 mit dem Spiegelkörper 32 verbunden ist. Der Haltekörper 30 bildet hierbei die Verbindung des Spiegel-Elements 19 zum Gelenkkörper 28.

Das Substrat 21 bildet eine den Aktuatorstift 29 umgebende Hülse. In der Hülse sind jeweils insgesamt vier Aktuator-Elektroden 33 integriert. Die Aktuator-Elektroden 33 sind jeweils paarweise einander gegenüberliegend angeordnet. Sie stellen Gegenelektroden zum als Elektrodenstift ausgebildeten Aktuatorstift 29 dar. Prinzipiell ist es auch möglich, eine andere Anzahl an Aktuator-Elektroden 33 je Aktuatorstift 29 vorzusehen. Es können insbesondere jeweils mindestens zwei Aktuator-Elektroden 33 je Verlagerungsfreiheitsgrad vorgesehen sein. Durch Erzeugen einer Potenzialdifferenz zwischen einer oder mehrerer der Aktuator-Elektroden 33 beziehungsweise zwischen Aktuator-Elektrode 33 und Aktuator-Stift 29 lässt sich eine elektrostatische Kraft auf den Aktuatorstift 29 erzeugen, welche zu einer Auslenkung des Spiegel-Elements 19 führen kann.

Für weitere Details insbesondere der Anordnung der Spiegel-Elemente 19 im Substrat 21 und deren Verschwenkbarkeit mittels der Aktuatoren sowie der Ausbildung der Gelenkkörper und der Wärmeleitungsabschnitte 22 sei außerdem auf die WO 2010/049076 A2 verwiesen.

Die Spiegel-Elemente 19 sind auf einer substratartigen Tragestruktur 34 angeordnet. Die Tragestruktur 34 ist auf der Rückseite der Spiegel-Elemente 19 angeordnet. In die Tragestruktur 34 ist eine Vielzahl von Signalleitungen 36 integriert. Die Signalleitungen 36 sind in den Figuren zur Verdeutlichung nicht entsprechend ihrer tatsächlichen Anordnung in der Tragestruktur 34, sondern nach Art eines elektrischen Schaltbildes schematisch dargestellt. Dies gilt ebenso für eine Treiberstufe 37 einer Verlagerungs-Einrichtung zur Verlagerung der Spiegel-Elemente 19. Die Treiberstufen 37 können ebenfalls in die Tragestruktur 34 integriert sein. Die Treiberstufen 37 können ebenfalls als ASIC ausgebildet sein. Die Treiberstufen 37 werden über Signalleitungen 38, welche ebenfalls nur schematisch dargestellt sind, mit Aktuierungssignalen versorgt. Für konstruktive Details der Anordnung der Signalleitungen 38 in der Tragestruktur 34 sei wiederum auf die WO 2013/120926 A1 verwiesen. Die Aktuator-Elektroden 33 können insbesondere auch als Kamm-Elektroden ausgebildet sein oder Kamm-Elektroden umfassen. In diesem Fall sind vorzugsweise am Aktuatorstift 29 und/oder am Spiegelkörper 32 hierzu korrespondierende Kamm-Strukturen vorgesehen. Für weitere Details der Ausbildung der Aktuator-Elektroden 33 als Kamm-Elektroden sei auf die DE 10 2013 206 531 A1 verwiesen, die hiermit als Bestandteil der vorliegenden Anmeldung in diese integriert ist.

In die Tragestruktur 34 ist insbesondere eine Steuerelektronik zur Steuerung der Verlagerung der Spiegel-Elemente 19 integriert. Die Steuerelektronik kann auch auf der Tragesturktur 34 angeordnet sein. Die Steuerelektronik ist insbesondere als anwendungsspezifische integrierte Schaltung 35 (englisch: Application Specific Integrated Circuit, ASIC) ausgebildet. Die in den Figuren dargestellte Anordnung des ASIC 35 dient lediglich der prinzipiellen Erläuterung. Sie entspricht nicht notwendigerweise der tatsächlichen Anordnung. Die ASICs 35 können insbesondere gekapselt, das heißt flüssigkeitsdicht, insbesondere gasdicht, abgeschlossen auf oder in der Tragestruktur 34 angeordnet sein. Dies ist für die Anwendung in einer Vakuumumgebung vorteilhaft.

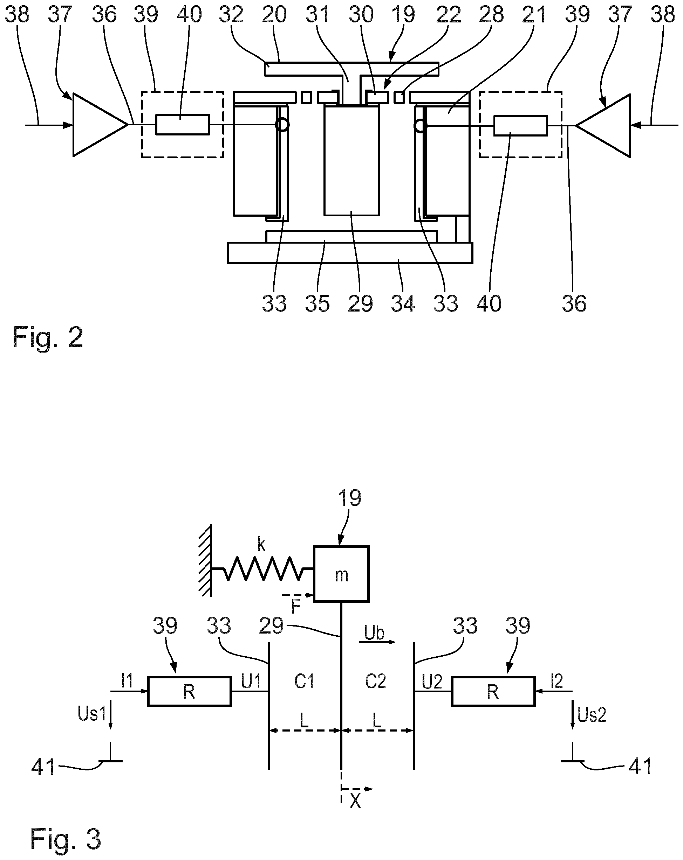

Im Folgenden werden unter Bezugnahme auf die Fig. 2 bis 7 weitere Aspekte der Vielspiegel-Anordnung mit einer Vielzahl der Spiegel-Elemente 19 beschrieben.

Wie bereits beschrieben, ist die Beleuchtungsoptik 4 in der evakuierbaren Kammer 23 angeordnet. Die Spiegel-Elemente 19 sind insbesondere in einer Umgebung mit einem sehr geringen Druck angeordnet. Dies führt zu einem extrem niedrigen Dämpfungskoeffizienten, was insbesondere dazu führt, dass die Spiegel-Elemente 19 sehr sensitiv auf mechanische Störungen, insbesondere bei Resonanzfrequenzen, reagieren. Erfindungsgemäß sind daher Dämpfungsmittel 39 zur Dämpfung von Störungen der Verlagerungspositionen der Spiegel-Elemente 19 vorgesehen. Als Dämpfungsmittel 39 dienen insbesondere passive elektrische Dämpfungsmittel. Die Dämpfungsmittel 39 umfassen insbesondere ausschließlich passive Dämpfungsmittel. Bei der in Fig. 2 dargestellten Alternative umfassen die Dämpfungsmittel 39 jeweils einen Reihenwiderstand 40. Der Reihenwiderstand 40 ist jeweils mit einer der Aktuator-Elektroden 33 in Reihe geschaltet. Er führt zu einer Dissipation von Energie bei Oszillationen des entsprechenden Spiegel-Elements 19.

Im Folgenden werden die unterschiedlichen Alternativen jeweils im Hinblick auf die Verlagerung des Spiegel-Elements 19 in einer Verlagerungsrichtung beschrieben. In einer bevorzugten Ausführungsform ist jedes Paar der Aktuator-Elektroden 33, insbesondere jede der Aktuator-Elektroden 33, mit entsprechenden Dämpfungsmitteln 39 versehen. Die Dämpfungsmittel 39 können insbesondere für die einzelnen Aktuator-Elektroden 33 jeweils identisch ausgebildet sein. Es ist auch möglich, unterschiedliche der Aktuator-Elektroden 33 mit unterschiedlichen Dämpfungsmitteln 39 zu versehen. Hierdurch ist eine gezielte Anpassung der Dämpfungsmittel 39 an gegebenenfalls unterschiedliche Details der Aktuator-Elektroden 33 möglich.

Die erfindungsgemäß vorgesehene Idee der Anordnung von passiven elektrischen Dämpfungsmitteln 39 lässt sich prinzipiell auf beliebige, insbesondere auf beliebige elektrostatische Aktuator-Ausbildungen übertragen oder anpassen.

In Fig. 3 ist schematisch ein elektromechanisches Modell des Spiegel-Elements 19 gemäß Fig. 2 dargestellt. Statt einer Kippbewegung wird vereinfacht eine Translation betrachtet. In dem Modell gemäß Fig. 3 werden die folgenden Bezeichnungen verwendet:
m: Masse des Spiegel-Elements 19
k: Steifigkeit der Aufhängung des Spiegel-Elements 19, insbesondere Steifigkeit des Gelenkkörpers 28,
F: extern auf das Spiegel-Element 19 wirkende Kraft
C1, C2: Kapazitäten zwischen den Aktuator-Elektroden 33 und dem Aktuatorstift 29
x: Auslenkung des Spiegel-Elements relativ zu einem bestimmten Arbeitspunkt
Ub: Bias-Spannung am Akuatorstift 29
U1, U2: an die Aktuator-Elektroden 33 angelegte Spannungen
Us1, Us2: Aktuierungsspannungen (Ausgangsspannung der Verstärker)
Us₁₀, Us₂₀: Arbeitspunkt der Ausgangsspannung der Verstärker
I1, I2: Strom der Aktuierungssignale
R: effektiver Ohmscher Widerstand der Dämpfungsmittel 39
L: Abstand des Aktuatorstifts 29 von den Aktuator-Elektroden 33 im Arbeitspunkt.

Zur Analyse des dynamischen Verhaltens des Spiegel-Elements 19 wurde eine Systemgleichung hergeleitet und am Arbeitspunkt linearisiert. Die Systemgleichung kann in allgemeiner Form wie folgt dargestellt werden y^{.} = Ay + Bu, wobei A die Systemmatrix bezeichnet und u die externen Inputs zum Spiegel-Element, insbesondere externe mechanische Kräfte und Aktuierungsspannungen.

Die Dämpfung in diesem System kann über die Eigenwerte der Systemmatrix A hergeleitet werden. Aus den Real- und Imaginärteilen dieser Eigenwerte lässt sich insbesondere der Dämpfungskoeffizient bestimmen.

Umgekehrt kann bei gegebenen Kapazitäten, Kapazitäts-Gradienten, Masse m und Steifigkeit k hergeleitet werden, welcher Wert für den Widerstand R erforderlich ist, um eine bestimmte Dämpfung zu erzielen.

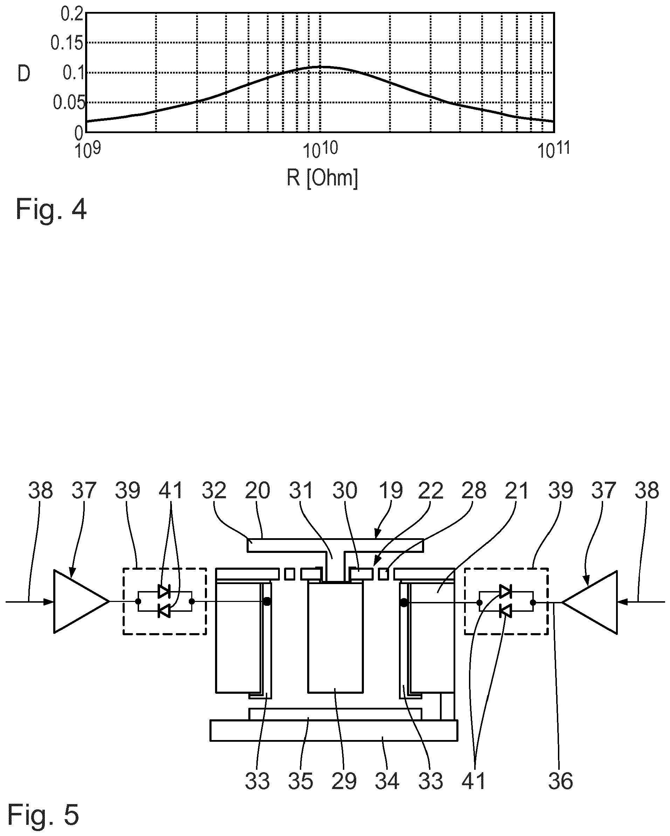

Für ein exemplarisches, realistisches Design der Spiegel-Elemente 19 wurde der Zusammenhang zwischen der Dämpfung und dem Widerstand R untersucht. Das Ergebnis ist exemplarisch in Fig. 4 dargestellt. Hierbei wurden die folgenden Werte zugrunde gelegt: Ub = -100 V, L = 50 µm, Fläche A der Aktuator-Elektroden 33: A = 1,6 ^{∗} 10⁻⁷ m², Masse m = 1,2 ^{∗} 10⁻⁷ kg, Steifigkeit k = 0,7 N/m.

Wie aus der Fig. 4 ersichtlich ist, wird bei den angegebenen Werten der Parameter des elektromechanischen Systems ein Widerstand R in der Grö-ßenordnung von GΩ benötigt, um eine Dämpfung von mindestens 0,01 zu erreichen.

Wie sich im Rahmen erster Untersuchungen entgegen erster Erwartungen herausstellte, ist jedoch bereits eine Dämpfung von ca. 0,001 ausreichend für die hier vorgesehenen Anwendungen. Ein derartiger Wert der Dämpfung kann für MEMS-Mikrospiegel mit Widerständen R im Bereich von Megaohm, insbesondere im Bereich von weniger als 100 MΩ, beispielsweise mit einem Widerstand im Bereich von 10 MΩ bis 20 MΩ erreicht werden.

Ein Widerstand R im Bereich von 10 MΩ bis 100 MΩ, insbesondere weniger als 50 MΩ, insbesondere von weniger als 30 MΩ, insbesondere von etwa 20 MΩ, hat den Vorteil, dass die im MEMS-Bauteil stets vorhandenen Leckströme nicht zu unerwünscht hohen Spannungsabfällen am Reihenwiderstand 40 führen. Der Spannungsabfall am Reihenwiderstand 40 beträgt insbesondere höchstens 10 %, insbesondere höchstens 5 %, insbesondere höchstens 3 %, insbesondere höchstens 2 %, insbesondere höchstens 1 % der Aktuatorspannung, bei welcher der volle Verlagerungsumfang des Spiegel-Elements 19 erreicht wird.

Weiter sei angemerkt, dass die Fig. 4 die Verhältnisse in einem bestimmten Setup mit Aktuator-Elektroden 33 gemäß der in Fig. 2 dargestellten Ausführungsform darstellt. Für Kamm-Elektroden, welche eine höhere Kapazität und höhere Kapazitätsgradienten haben, kann eine gute Dämpfung schon mit geringeren Widerständen erreicht werden.

Im Folgenden wird unter Bezugnahme auf die Fig. 5 eine alternative Ausführungsform der Vielspiegel-Anordnung mit Dämpfungsmitteln 39 beschrieben. Identische Teile erhalten dieselben Bezugszeichen wie bei dem vorhergehend beschriebenen Ausführungsbeispiel, auf dessen Beschreibung hiermit verwiesen wird.

Die Reihenwiderstände 40 sind als on-ASIC-Strukturen, das heißt als Strukturen auf der anwendungsspezifischen Schaltung, ausgebildet. Sie können in der Ausführungsform nach Fig. 2 als N-Well (N+Poly)-Widerstand ausgebildet sein. Derartige Widerstände lassen sich mit bis zu 5 kΩ/sq. herstellen. Für einen 20 MΩ-Widerstand benötigt man daher 4000 Squares. Der Reihenwiderstand 40 kann insbesondere als mäanderförmige Struktur ausgebildet sein. Er kann auf einer Fläche von 16000 µm² untergebracht werden.

Bei einer differenziellen und zweiachsigen Ansteuerung des Spiegel-Elements 19 sind vier Reihenwiderstände 40 vorgesehen.

Bei dem in Fig. 5 dargestellten Ausführungsbeispiel umfassen die Dämpfungsmittel 39 anstelle des Reihenwiderstandes 40 jeweils zwei antiparallel geschaltete Dioden 41. Die Dioden 41 weisen einen geringen Sättigungssperrstrom auf. Der Sättigungssperrstrom kann insbesondere im Bereich von 1 pA bis 100 pA, insbesondere im Bereich von 3 pA bis 30 pA, insbesondere im Bereich von 5 pA bis 20 pA liegen. Als Dioden 41 können Bauelemente beispielsweise mit einer Charakteristik ähnlich denen von Fairchild FJH1100-Bauelementen eingesetzt werden.

Die Dioden 41 haben vorzugsweise einen sehr hohen differenziellen Widerstand, zumindest in bestimmten Strom-/Spannungsarbeitsbereichen. Der differenzielle Widerstand (Kehrwert des Leitwerts) kann beispielsweise im Bereich des Stromnulldurchgangs bei rund 4,2 GΩ liegen. Dies ist der Wert des vorhergehend genannten Fairchild FJH1100-Bauelements.

Die Dioden 41 können zu einem nicht-linearen Dämpfungseffekt führen. In den Stromnulldurchgängen beziehungsweise um die Stromnulldurchgänge herum, wie sie bei unerwünschten Schwingungen des Spiegel-Elements 19 auftreten, hat die Diode 41 jedoch einen ausreichend hohen differenziellen Widerstand. Es hat sich gezeigt, dass die erfindungsgemäße Anordnung zweier anti-parallel geschalteter Dioden 41 zur Dämpfung des Spiegel-Elements 19 ausreichend sein kann.

Die Dioden 41 sind als on-ASIC-Strukturen ausgebildet. Sie sind insbesondere jeweils als Strukturen mit einer Größe von etwa 30 µm ^{∗} 30 µm ausgebildet. Der Leckstrom einer derartigen Struktur liegt bei etwa 10 pA.

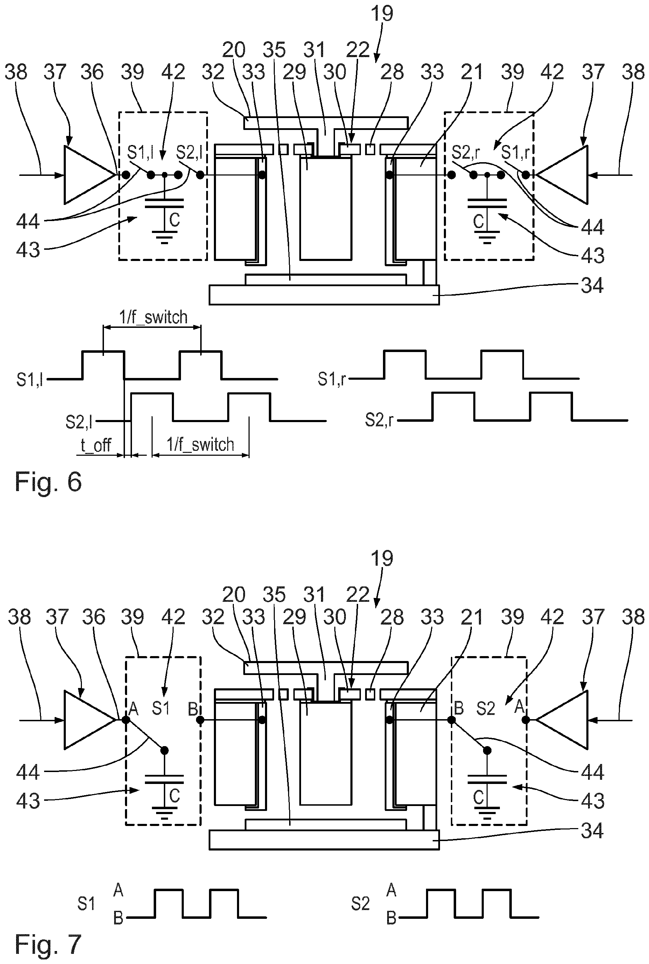

Im Folgenden wird unter Bezugnahme auf die Fig. 6 eine weitere Alternative der Vielspiegel-Anordnung mit passiven Dämpfungsmitteln 39 beschrieben. Identische Bestandteile erhalten dieselben Bezugszeichen wie bei den vorhergehend beschriebenen Ausführungsbeispielen, auf die hiermit verwiesen wird.

Bei dem Ausführungsbeispiel gemäß Fig. 6 umfassen die Dämpfungsmittel 39 jeweils eine sogenannte Schaltkondensatorstruktur (Switched Capacitor Structure, Switched Capacitor Resistor). Eine derartige Struktur verhält sich und wirkt wie ein Widerstand zwischen den Anschlussstellen A und B. Eine derartige Struktur kann besonders einfach als on-ASIC-Struktur ausgebildet sein. Sie weist einen sehr genau einstellbaren Widerstand auf. Der Widerstand kann insbesondere über die Schaltfrequenz feingetunt werden. Eine derartige Struktur ist thermisch sehr stabil. Außerdem weist eine derartige Struktur den Vorteil auf, dass sich Kapazitäten sehr genau als on-ASIC-Strukturen realisieren lassen.

Die in der Fig. 6 dargestellte Schaltkondensatorstruktur 42 umfasst jeweils einen Kondensator 43 und zwei Schalter 44.

In der Fig. 6, unterer Teil, ist exemplarisch ein Schaltschema für die Schalter 44 der beiden Schaltkondensatorstrukturen 42 dargestellt. Die oberen Stellungen der Kurve bedeutet hierbei jeweils, dass der entsprechende Schalter 44 geschlossen ist. Die Totzeit (t_off), während welcher beide Schalter 44 einer Schaltkondensatorstruktur 42 offen sind, ist nicht maßstabsgerecht dargestellt. Die Totzeit ist üblicherweise wesentlich kürzer als es in der Fig. 6 dargestellt ist. Mit dem dargestellten Schaltschema verhält sich die Schaltkondensatorstruktur 42 wie ein Widerstand.

Die Schaltfrequenz der Schaltkondensatorstruktur 42 liegt mindestens 2 Dekaden oberhalb der ersten Kipp-Resonanz des Spiegel-Elements 19. Letztere liegt üblicherweise im Bereich von 100 Hz bis 1000 Hz, insbesondere im Bereich von 300 Hz bis 600 Hz. Die Schaltfrequenz der Schaltkondensatorstruktur 42 kann insbesondere oberhalb von 100 kHz liegen. Sie liegt insbesondere im Bereich von 10 kHz bis 10 MHz.

Die Kapazität C des Kondensators 43 liegt insbesondere im Bereich von Femtofarad oder Picofarad. Sie kann insbesondere im Bereich von 100 fF bis 5 pF, insbesondere im Bereich von 200 fF bis 3 pF, insbesondere im Bereich von 300 fF bis 2 pF, insbesondere bei mindestens 500 fF, insbesondere bei höchstens 1 pF liegen. Für den Kondensator 43 wird eine on-ASIC-Fläche von etwa 500 µm² benötigt. Die für die Schalter 44 benötigte Fläche liegt in einem ähnlichen Bereich. Der gesamte Flächenbedarf für die Schaltkondensatorstruktur 42 beträgt daher etwa 1500 µm².

Die Schaltkondensatorstruktur 42 hat einen besonders geringen Flächenbedarf (geringer Footprint). Sie hat außerdem den Vorteil, dass sie keine oder zumindest keine ausgeprägte Nichtlinearität aufweist.

Einzelne Teile des Dämpfungsmittels können auch zumindest kurzzeitig parallel zu den Aktuator-Elektroden geschaltet sein. Dies lässt sich beispielsweise in Fig. 6 erkennen. Das gesamthaft zum Aktuator in Reihe geschaltete Dämpfungsmittel 39 enthält einen Kondensator 43 als Teil einer Switched-Capacitor-Einheit. Der Kondensator 43 wird gemäß Fig. 6 kurzzeitig mit der Masse (Ground, GND) verbunden. Ist zum Beispiel der Aktuatorstift 29 ebenfalls mit Masse (Ground, GND) verbunden ergibt sich bei kurzzeitig geschlossenem Schalter S2 (Fig. 6, 42) eine kurzzeitige Parallelschaltung des Kondensators 43 zum Aktuator beziehungsweise zur Aktuatorkapazität. Das gesamte Dämpfungsmittel 39 kann bzgl. seiner Wirksamkeitweiterhin als Reihenschaltung mit dem Aktuator betrachtet werden.

In Fig. 7 ist eine Variante der in Fig. 6 dargestellten Ausführungsform dargestellt. Bei dieser Variante umfasst die Schaltkondensatorstruktur 42 außer dem Kondensator 43 jeweils nur einen einzigen Schalter 44. Der Schalter 44 ist zwischen den beiden Anschlussstellen A und B hin und her schaltbar. Diese Alternative weist ein besonders einfaches, insbesondere ein besonders einfach zu realisierendes Design auf.

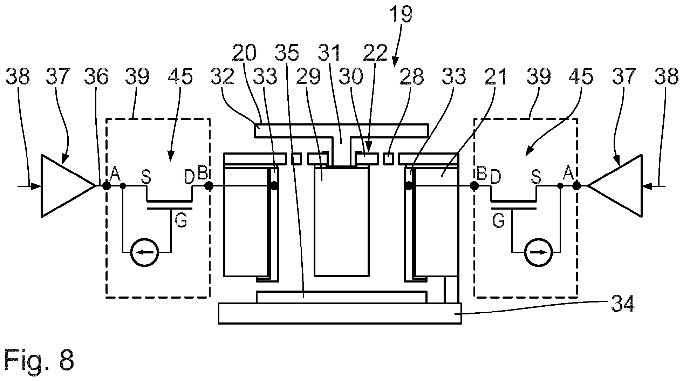

Das Dämpfungsmittel 39 kann auch eine andere Ausbildung aufweisen. Es ist insbesondere möglich, die Widerstände der Dämpfungsmittel 39 mit Transistoren 45 zu bilden, beispielsweise dadurch, dass das Gatter G (Gate G) auf eine feste Spannung unterhalb der Schwellen-Spannung gelegt wird. Eine entsprechende Variante ist schematisch in der Fig. 8 dargestellt.

Bei der in Fig. 8 dargestellten Variante ist die Quelle (Source S) jeweils auf der der Treiberstufe 37 zugewandten Seite angeordnet. Die Senke (Drain D) ist auf der der Aktuator-Elektrode 31 zugewandten Seite angeordnet. Je nachdem, was für ein Transistortyp für den Transistor 45 vorgesehen ist, müssen Drain und Source gegebenenfalls vertauscht werden. Dies kann zum Beispiel dann der Fall sein, wenn ein Transistortyp zum Einsatz kommt, der zwischen Drain und Source ein stark asymmetrisches Strom-Spannungs-Verhalten hat.

Je nach Typ des Transistors 45 kann auch vorgesehen sein, das Dämpfungsmittel 39 jeweils durch zwei Transistoren 45 zu bilden, um einen Widerstand zu erhalten, der in beide Richtungen einen ähnlichen Widerstandswert aufweist.

Gemäß einer Alternative kann auch vorgesehen sein, Gate und Source direkt miteinander zu verbinden, das heißt kurzzuschließen. Die Gate-Source-Spannung ist dann gleich 0. Der Widerstand wäre dann gerade gleich dem Widerstand des Transistors 45 im ausgeschalteten Zustand.

Alternativ hierzu kann auch ein festes Gate-Potential gegenüber Masse (Ground, GND) vorgesehen sein. Die Gate-Source-Spannung ist dann wegen der Schwankung der Ansteuerungsspannung (an den Punkten A im Schaltbild gemäß Fig. 8) nicht mehr konstant. Es hat sich ergeben, dass die sich ergebenden Drain-Source-Widerstände der Transistoren 45 trotzdem zur Dämpfung beitragen können.

Gemäß einer weiteren Alternative ist vorgesehen, jeweils mehrere Transistoren 45 mit einer festen Gate-Source-Spannung in Serie zu schalten. Das Dämpfungsmittel 39 kann insbesondere durch eine Serienschaltung von mehreren Transistoren 45 mit festen Gate-Source-Spannungen gebildet sein.

Auch mit durch Transistoren gebildeten Widerständen lässt sich der gewünschte Widerstandswert von beispielsweise 20 MΩ gut realisieren.

Gemäß weiteren Alternativen ist im Aktuator-Pfad, das heißt in der Signalleitung 36, zwischen der Treiberstufe 37 und den Aktuator-Elektroden 33 jeweils ein Tiefpassfilter, insbesondere ein analoger Tiefpassfilter, vorgesehen. Der Tiefpassfilter weist vorzugsweise eine Grenzfrequenz von etwa 1000 Hz auf. Er weist eine Dämpfung von mindestens 25 dB ab einer Frequenz von 10 kHz auf. Ein entsprechender Filter kann bei sämtlichen vorhergehend beschriebenen Alternativen vorgesehen sein.

## Patentansprüche

1. Vielspiegel-Anordnung für eine Beleuchtungsoptik (4) einer Projektionsbelichtungsanlage (1) für die Mikrolithographie umfassend
1.1 eine Vielzahl von verlagerbaren Spiegel-Elementen (19) mit Reflexionsflächen (20),
1.2 eine Vielzahl von Aktuatoren zur Verlagerung der SpiegelElemente (19), und
1.3 eine Vielzahl von passiven elektrischen Dämpfungsmitteln (39) zur Dämpfung von Störungen der Verlagerungspositionen der SpiegelElemente (19),
1.4 wobei die Aktuatoren zur Verlagerung eines der Spiegel-Elemente (19) jeweils mindestens eine Aktuator-Elektrode (33) aufweisen, welche mittels einer Signalleitung (36) mit einem Aktuations-Signal beaufschlagbar ist,
1.5 wobei die Dämpfungsmittel (39) zur Dämpfung von Störungen der Verlagerungspositionen der Spiegel-Elemente (19) jeweils in Reihenschaltung mit einer der Aktuator-Elektroden (33) angeordnet sind,
1.6 **dadurch gekennzeichnet, dass** die Dämpfungsmittel (39) mindestens ein Mittel ausgewählt aus der Gruppe von anti-parallel geschaltete Dioden, Schaltkondensatorstrukturen und Transistorschaltungen umfassen.

2. Vielspiegel-Anordnung gemäß Anspruch 1, **dadurch gekennzeichnet, dass** die Dämpfungsmittel (39) jeweils als Energie-Dissipations-Einrichtung ausgebildet sind.

3. Vielspiegel-Anordnung gemäß einem der vorhergehenden Ansprüche, **dadurch gekennzeichnet, dass** die Dämpfungsmittel (39) variabel einstellbar sind.

4. Vielspiegel-Anordnung gemäß einem der vorhergehenden Ansprüche, **dadurch gekennzeichnet, dass** die Dämpfungsmittel (39) jeweils als on-ASIC Strukturen ausgebildet sind.

5. Vielspiegel-Anordnung gemäß einem der vorhergehenden Ansprüche, **dadurch gekennzeichnet, dass** die Dämpfungsmittel (39) jeweils als Strukturen mit einer Fläche von höchstens 10 % der Reflexionsfläche des zugehörigen Spiegel-Elements (19) ausgebildet sind.

6. Vielspiegel-Anordnung gemäß einem der vorhergehenden Ansprüche, **dadurch gekennzeichnet, dass** die Dämpfungsmittel (39) jeweils einen effektiven Serienwiderstand im Bereich von 1 MΩ bis 100 G2 aufweisen.

7. Vielspiegel-Anordnung gemäß einem der vorhergehenden Ansprüche, **dadurch gekennzeichnet, dass** die Dämpfungsmittel (39) mindestens eine Schaltkondensatorstruktur (42) aufweisen mit einer Schaltfrequenz im Bereich von 10 kHz bis 10 MHz.

8. Vielspiegel-Anordnung gemäß einem der vorhergehenden Ansprüche, **dadurch gekennzeichnet, dass** im Aktuatorpfad ein Tiefpassfilter vorgesehen ist mit einer Grenzfrequenz von 1000 Hz und einer Dämpfung von mindestens 25 dB ab einer Frequenz von 10 kHz.

9. Facettenspiegel (13, 14) für eine Beleuchtungsoptik (4) einer Projektionsbelichtungsanlage (1) umfassend mindestens eine Vielspiegel-Anordnung gemäß einem der Ansprüche 1 bis 8.

10. Beleuchtungsoptik (4) für eine Projektionsbelichtungsanlage (1) umfassend mindestens einen Facettenspiegel (13, 14) gemäß Anspruch 9.

11. Beleuchtungssystem (2) für eine Projektionsbelichtungsanlage (1) umfassend
9.1 eine Beleuchtungsoptik (4) gemäß Anspruch 10 und
9.2 eine Strahlungsquelle (3) zur Erzeugung von Beleuchtungsstrahlung (10).

12. Projektionsbelichtungsanlage (1) für die Mikrolithographie umfassend mindestens eine Beleuchtungsoptik (4) gemäß Anspruch 10.

13. Verfahren zur Herstellung eines mikro- oder nanostrukturierten Bauelements umfassend die folgenden Schritte:
13.1 Bereitstellen eines Substrats, auf das zumindest teilweise eine Schicht aus einem lichtempfindlichen Material aufgebracht ist,
13.2 Bereitstellen eines Retikels, das abzubildende Strukturen aufweist,
13.3 Bereitstellen einer Projektionsbelichtungsanlage (1) gemäß Anspruch 12,
13.4 Projizieren wenigstens eines Teils des Retikels auf einen Bereich der lichtempfindlichen Schicht des Substrats mit Hilfe der Projektionsbelichtungsanlage (1).

## Claims

1. Multi-mirror array for an illumination optical unit (4) of a projection exposure apparatus (1) for microlithography comprising
1.1 a multiplicity of displaceable mirror elements (19) having reflection areas (20),
1.2 a multiplicity of actuators for displacing the mirror elements (19), and
1.3 a multiplicity of passive electrical damping means (39) for damping disturbances of the displacement positions of the mirror elements (19),
1.4 wherein the actuators have for displacing one of the mirror elements (19) in each case at least one actuator electrode (33), to which an actuation signal can be applied by means of a signal line (36),
1.5 wherein the damping means (39) for damping disturbances of the displacement positions of the mirror elements (19) are arranged in each case in a manner connected in series with one of the actuator electrodes (33),
1.6 **characterized in that** the damping means (39) comprise at least one means selected from the group of antiparallel-connected diodes, switched capacitor structures and transistor circuits.

2. Multi-mirror array according to Claim 1, **characterized in that** the damping means (39) are embodied in each case as an energy dissipation device.

3. Multi-mirror array according to either of the preceding claims, **characterized in that** the damping means (39) are variably adjustable.

4. Multi-mirror array according to any of the preceding claims, **characterized in that** the damping means (39) are embodied in each case as on-ASIC structures.

5. Multi-mirror array according to any of the preceding claims, **characterized in that** the damping means (39) are embodied in each case as structures having an area of at most 10% of the reflection area of the associated mirror element (19).

6. Multi-mirror array according to any of the preceding claims, **characterized in that** the damping means (39) have in each case an effective series resistance in the range of 1 MΩ to 100 GΩ.

7. Multi-mirror array according to any of the preceding claims, **characterized in that** the damping means (39) have at least one switched capacitor structure (42) having a switching frequency in the range of 10 kHz to 10 MHz.

8. Multi-mirror array according to any of the preceding claims, **characterized in that** a low-pass filter having a cut-off frequency of 1000 Hz and a damping of at least 25 dB starting from a frequency of 10 kHz is provided in the actuator path.

9. Facet mirror (13, 14) for an illumination optical unit (4) of a projection exposure apparatus (1), comprising at least one multi-mirror array according to any of Claims 1 to 8.

10. Illumination optical unit (4) for a projection exposure apparatus (1) comprising at least one facet mirror (13, 14) according to Claim 9.

11. Illumination system (2) for a projection exposure apparatus (1), comprising
9.1. an illumination optical unit (4) according to Claim 10 and
9.2. a radiation source (3) for generating illumination radiation (10).

12. Projection exposure apparatus (1) for microlithography comprising at least one illumination optical unit (4) according to Claim 10.

13. Method for producing a microstructured or nanostructured component, comprising the following steps:
13.1 providing a substrate, to which at least partly a layer composed of a light-sensitive material is applied,
13.2 providing a reticle which has structures to be imaged,
13.3 providing a projection exposure apparatus (1) according to Claim 12,
13.4 projecting at least one part of the reticle onto a region of the light-sensitive layer of the substrate with the aid of the projection exposure apparatus (1) .

## Revendications

1. Ensemble multi-miroirs destiné à l'optique d'éclairage (4) d'un système d'exposition à la lumière par projection (1) destiné à la microlithographie, ledit ensemble comprenant
1.1 un grand nombre d'éléments formant miroirs déplaçables (19) pourvus de surfaces réfléchissantes (20),
1.2 un grand nombre d'actionneurs destinés à déplacer les éléments formant miroirs (19), et
1.3 un grand nombre de moyens d'amortissement électriques passifs (39) destinés à amortir les perturbations dans les positions de déplacement des éléments formant miroirs (19),
1.4 les actionneurs destinés à déplacer l'un des éléments formant miroirs (19) comportant chacun au moins une électrode d'actionneur (33) qui peut être soumise à un signal d'actionnement au moyen d'une ligne de signal (36),
1.5 les moyens d'amortissement (39) destinés à amortir les perturbations dans les positions de déplacement des éléments formant miroirs (19) étant disposés chacun en série avec l'une des électrodes d'actionnement (33),
1.6 **caractérisé en ce que**
les moyens d'amortissement (39) comprennent au moins un moyen choisi dans le groupe comportant les diodes à montage antiparallèle, les structures à condensateurs commutés et les circuits de transistors.

2. Ensemble multi-miroirs selon la revendication 1, **caractérisé en ce que** les moyens d'amortissement (39) sont conçus chacun comme un dispositif de dissipation d'énergie.

3. Ensemble multi-miroirs selon l'une des revendications précédentes, **caractérisé en ce que** les moyens d'amortissement (39) sont réglables de manière variable.

4. Ensemble multi-miroirs selon l'une des revendications précédentes, **caractérisé en ce que** les moyens d'amortissement (39) sont chacun conçus comme des structures on-ASIC.

5. Ensemble multi-miroirs selon l'une des revendications précédentes, **caractérisé en ce que** les moyens d'amortissement (39) sont conçus chacun comme des structures ayant une surface d'au plus 10 % de la surface réfléchissante de l'élément formant miroir associé (19).

6. Ensemble multi-miroirs selon l'une des revendications précédentes, **caractérisé en ce que** les moyens d'amortissement (39) comportent chacun une résistance série effective dans la gamme allant de 1 MΩ à 100 GΩ.

7. Ensemble multi-miroirs selon l'une des revendications précédentes, **caractérisé en ce que** les moyens d'amortissement (39) comportent au moins une structure à condensateurs commutés (42) ayant une fréquence de commutation dans la gamme allant de 10 kHz à 10 MHz.

8. Ensemble multi-miroirs selon l'une des revendications précédentes, **caractérisé en ce qu'**un filtre passe-bas, ayant une fréquence de coupure de 1000 Hz et une atténuation d'au moins 25 dB à partir d'une fréquence de 10 kHz, est prévu dans le trajet de l'actionneur.

9. Miroir à facettes (13, 14) destiné à une optique d'éclairage (4) d'un système d'exposition à la lumière par projection (1), ledit miroir à facettes comprenant au moins un ensemble multi-miroirs selon l'une des revendications 1 à 8.

10. Optique d'éclairage (4) destinée à un système d'exposition à la lumière par projection (1), ladite optique d'éclairage comprenant au moins un miroir à facettes (13, 14) selon la revendication 9.

11. Système d'éclairage (2) destiné à un système d'exposition à la lumière par projection (1), ledit système d'éclairage comprenant
9.1 une optique d'éclairage (4) selon la revendication 10 et
9.2 une source de rayonnement (3) destinée à générer un rayonnement d'éclairage (10).

12. Système d'exposition à la lumière par projection (1) destiné à la microlithographie, ledit système d'exposition à la lumière par projection comprenant au moins une optique d'éclairage (4) selon la revendication 10.

13. Procédé de fabrication d'un composant microstructuré ou nano-structuré, ledit procédé comprenant les étapes suivantes :
13.1 fournir un substrat sur lequel une couche d'un matériau photosensible est au moins partiellement appliquée,
13.2 fournir un réticule qui comporte des structures à reproduire,
13.3 fournir un système d'exposition à la lumière par projection (1) selon la revendication 12,
13.4 projeter au moins une partie du réticule sur une zone de la couche photosensible du substrat à l'aide du système d'exposition à la lumière par projection (1) .
